# EUROPEAN PATENT APPLICATION

(11) **EP 4 411 394 A1**
(43) Date of publication of application: **07.08.2024**
(21) Application number: 24151709.3
(22) Date of filing: 12.01.2024
(51) Int. Cl.: G01R 29/08, G01R 31/00

(54) **METHODS AND SYSTEMS FOR DETERMINING ELECTROMAGNETIC COMPATIBILITY FOR A TARGET ELECTRICAL DEVICE BY AN UNMANNED AERIAL SYSTEM**

(30) Priority: 13.01.2023 SE 2350028
(71) Applicant: EMC Mapping Sweden AB, 417 55 Göteborg (SE)
(72) Inventor: LINDERS, Jan, 422 49 Hisings Backa (SE)
(74) Representative: Bergenstråhle & Partners AB

(57) **Abstract**

A method for determining electromagnetic compatibility, EMC, for a target electrical device in a limited area around the target electrical device by means of an unmanned aerial system is provided. The method comprises: determining a route for the drone, and positioning the drone flying along the route; scanning the limited area around the target electrical device, and measuring, by the measuring unit of the drone, electromagnetic signal strength and frequency at different heights and/or locations around the target electrical device in the limited area; collecting operating conditions around the target electrical device in the limited area; transmitting the measured electromagnetic signal strength and frequency and collected operating conditions to the computing unit; selecting the electromagnetic signals which having frequencies outside the bandwidths authorized to radio communications; determining if the EMC of the target electrical device fulfills EMC requirement, wherein the collected operating conditions being additional information to the EMC determination result.

## Description

### Technical field

The present invention relates generally to methods and systems for electromagnetic compatibility (EMC) determination, and more particularly to methods and systems for determining EMC for a target electrical device in a limited area around the target electrical device by an unmanned aerial system.

### Background art

The electromagnetic environment around electrical device is important for understanding the performance of both the electrical device and other systems in the environment. With the development of technique and increase of system complexity, the need for understanding modern electromagnetic environment increases.

Electromagnetic compatibility (EMC) is a frequently used concept for understanding the electromagnetic environment which includes multiple electrical devices or electrical systems. EMC is the ability of electrical equipment and systems to function acceptably in their electromagnetic environment, by limiting the unintentional generation, propagation and reception of electromagnetic energy which may cause unwanted effects such as electromagnetic interference (EMI) or even physical damage in operational equipment. The goal of EMC is the correct operation of different equipment in a common electromagnetic environment. EMC requirements are defined through standards. If electrical equipment operates in a common electrical environment with other electrical equipment, the electrical equipment should fulfill the EMC requirements defined in the standards. Therefore, the electrical equipment would not disturb other electrical equipment in the sense of EMC in the common electrical environment. Usually, the EMC concept includes both emission and immunity, the term "EMC requirement" or "determining EMC" in this application document refers mostly to the emission.

For example, according to recent research, some installed solar energy plants systems have been shown to interfere with nearby base stations for mobile radio communications and military communications systems. Another example is airport systems. It is important to secure areas around airports so that the airport system is not affected by electromagnetic interference in the electromagnetic environment. It is also a legal requirement that the electrical device must function together with other electrical devices in the common electrical environment.

Therefore, for an electrical equipment which is going to be deployed/installed, it is beneficial to measure the EMC of the equipment, and to confirm that the EMC of the equipment fulfills the EMC requirement. In prior art, the EMC measurement usually takes place in a dedicated EMC measuring place, e.g., in a shielded chamber or at special outdoor EMC measuring place. The cost for building, purchasing or renting a dedicated EMC measuring place is usually high. Meanwhile, the space of the dedicated EMC measuring place is limited, so that the electrical equipment with large size may not be able to be measured in the dedicated EMC measuring place. Furthermore, there is also a requirement for the equipment which is already installed on-site to fulfill the EMC requirement.

Therefore, there is a need for a flexible, effective and cheap solution, so that the EMC measurement/determination of an electrical equipment can be performed locally, where the electrical equipment is deployed, that is an outdoor EMC measurement/determination on-site.

### Summary of invention

An object of the present invention is to provide a method and system for determining EMC of a target electrical device in a limited area around the target electrical device in a flexible, effective and economic way.

Another object of the present invention is to provide a method and system for testing electromagnetic susceptibility of a target electrical device in an accurate and flexible way without limitation of environment and operating conditions.

The above objectives are wholly or partially met by the method and system described in the appended claims. Features and different aspects are set forth in the appended claims, in the following description, and in the annexed drawings.

According to one embodiment, a method for determining electromagnetic compatibility, EMC, for a target electrical device in a limited area around the target electrical device by means of an unmanned aerial system is provided. The unmanned aerial system comprises a drone, an interface, a computing unit, and the drone comprises a positioning unit, a scanning unit, a measuring unit, a sensor and a transmitting unit. The method comprises: determining, by the interface, a route for the drone, and positioning, by the positioning unit, the drone flying along the route. The method further comprises scanning, by the scanning unit, the limited area around the target electrical device, and measuring, by the measuring unit of the drone, electromagnetic signal strength and frequency at different heights and/or locations around the target electrical device in the limited area. The method further comprises collecting, by the sensor, operating conditions around the target electrical device in the limited area, and transmitting, by the transmitting unit, the measured electromagnetic signal strength and frequency and collected operating conditions to the computing unit, and selecting, by the computing unit, the electromagnetic signals which having frequencies outside the bandwidths authorized to radio communications. The method further comprises determining, by the computing unit, if the EMC of the target electrical device fulfills EMC requirement by comparing the selected measured electromagnetic signal strength with respective threshold in corresponding frequencies; when the selected measured electromagnetic signal strength is lower than the threshold, the EMC of the target electrical device is determined to fulfil the EMC requirement in corresponding frequency, wherein the collected operating conditions being additional information to the EMC determination result.

In another embodiment, the drone further comprises a drone computing unit, so that the steps of selecting and determining can also be performed in the drone computing unit on at last a part of the electromagnetic signals.

In another embodiment, the method further comprises adjusting the route of the drone based on the measured electromagnetic signal strength, so that the drone flying towards the position where the measured electromagnetic signal strength is higher than a predefined strength threshold in a predetermined frequency.

In one embodiment, the measuring is made as a spot-measurement.

In another embodiment, the method further comprises presenting the determination result of EMC, the form of the presenting is at least one of the following: maps, tables, graphs, pictures and descriptive text.

In yet another embodiment, the method further comprises recording the height of the measuring spot, the geographic location of the measuring spot and measuring time.

In yet another embodiment, the method further comprises testing electromagnetic susceptibility of the target electrical device.

In yet another embodiment, the method further comprises determining electromagnetic disturbance based on the measured strength and frequency of the electromagnetic signal.

In another embodiment, an unmanned aerial system for determining electromagnetic compatibility, EMC, for a target electrical device in a limited area around the target electrical device, is provided. The unmanned aerial system comprises a drone, an interface and a computing unit. The drone comprises a positioning unit, a scanning unit, a measuring unit, a sensor, and a transmitting unit. The unmanned aerial system is operative for: determining, by the interface, a route for the drone, and positioning, by the positioning unit, the drone flying along the route. The unmanned aerial system is further operative for scanning, by the scanning unit, the limited area around the target electrical device, and measuring, by the measuring unit of the drone, electromagnetic signal strength and frequency at different heights and/or locations around the target electrical device in the limited area. The unmanned aerial system is further operative for collecting, by the sensor, operating conditions around the target electrical device in the limited area, and transmitting, by the transmitting unit, the measured electromagnetic signal strength and frequency and collected operating conditions to the computing unit. The unmanned aerial system is further operative for selecting, by the computing unit, the electromagnetic signals which having frequencies outside the bandwidths authorized to radio communications. The unmanned aerial system is further operative for determining, by the computing unit, if the EMC of the target electrical device fulfils EMC requirement by comparing the selected measured electromagnetic signal strength with respective threshold in corresponding frequencies; when the selected measured electromagnetic signal strength is lower than the threshold, the EMC of the target electrical device is determined to fulfil the EMC requirement in corresponding frequency, wherein the collected operating conditions being additional information to the EMC determination result.

By using the unmanned aerial system, the EMC of the target electrical device can be measured and determined on-site in a flexible and economic way.

### Brief description of drawings

The invention is now described, by way of example, with reference to the accompanying drawings, in which:
Fig. 1 is an exemplary overview of the whole system for the EMC measurement and determination.
Fig. 2 is an exemplary functional block of the unmanned aerial system for the EMC measurement and determination.
Fig. 3 is a flow chart showing an example of a method for determining EMC for a target electrical device by the unmanned aerial system.
Fig. 4 is an exemplary flying route for the drone.

### Description of embodiments

In the following, a detailed description of particular embodiments of the present disclosure are described herein-below with reference to the accompanying drawings; however, the disclosed embodiments are shown merely as examples of the disclosure and may be embodied in various other forms. Well-known functions or constructions are not described in detail to avoid obscuring the present disclosure in unnecessary detail. Therefore, specific structural and functional details disclosed herein are not to be interpreted as limiting, but merely as a basis for the claims and as a representative basis for teaching one skilled in the art to variously employ the present disclosure in virtually any appropriate detailed structure. Like reference numerals may refer to similar or identical elements throughout the description of the figures.

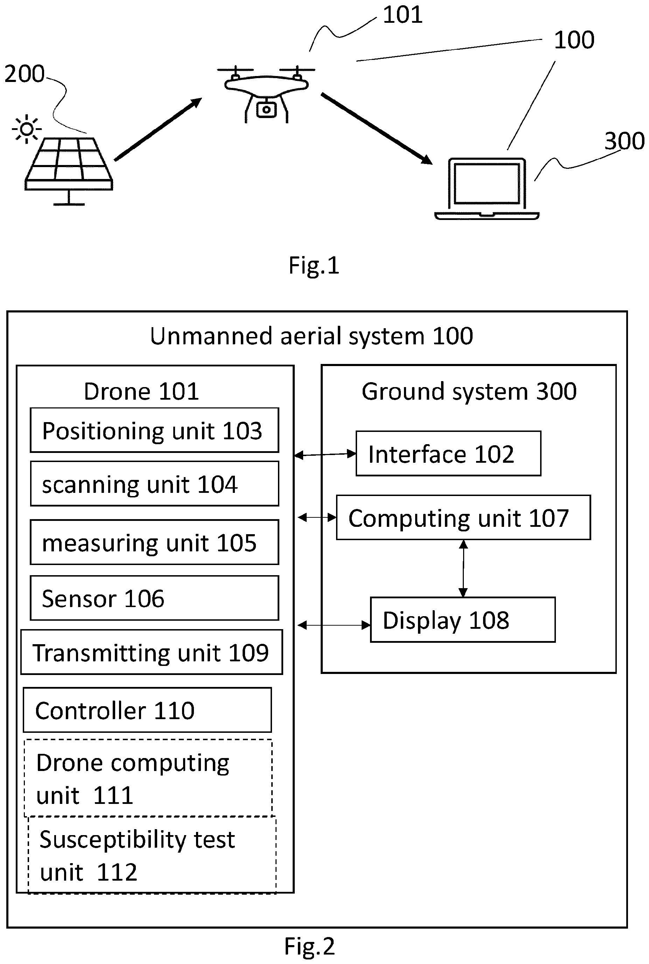

**Fig. 1** is an exemplary overview of the whole system for the EMC measurement and mapping the electronic environment.

The unmanned aerial system 100, which may also be called a drone system in the present invention, comprise a drone 101 and a ground system 300, the ground system 300 is used to control the drone 101, do computation and communicate between a user (not shown in the drawings) and the drone 101. The unmanned aerial system 100 will be explained in detail in combination with Fig. 2. The drone 101, which is also called unmanned aerial vehicle (UAV), is regarded as a flying platform which performs the measurement of electromagnetic emission and performs electromagnetic susceptibility test around a target electrical device 200. The target electrical 200 can be any kind of electrical device which has EMC requirement. The target electrical device 200 can be for example, solar energy plants, electrical lines, base stations for mobile radio communications and military communications systems, airport systems, vehicles, vessels, etc.

Now the details of the unmanned aerial system will be explained. Fig. 2 shows exemplary functional blocks of the unmanned aerial system for the EMC determination of the target electrical device 200. As illustrated above, the unmanned aerial system 100 comprises a drone 101 and a ground system 300. The ground system 300 may be a computer, a control panel, a host and a terminal etc. The functional blocks of the unmanned aerial system 100 can be distributed in the drone 101 and the ground system 300, some functional blocks can even be arranged as a separate system.

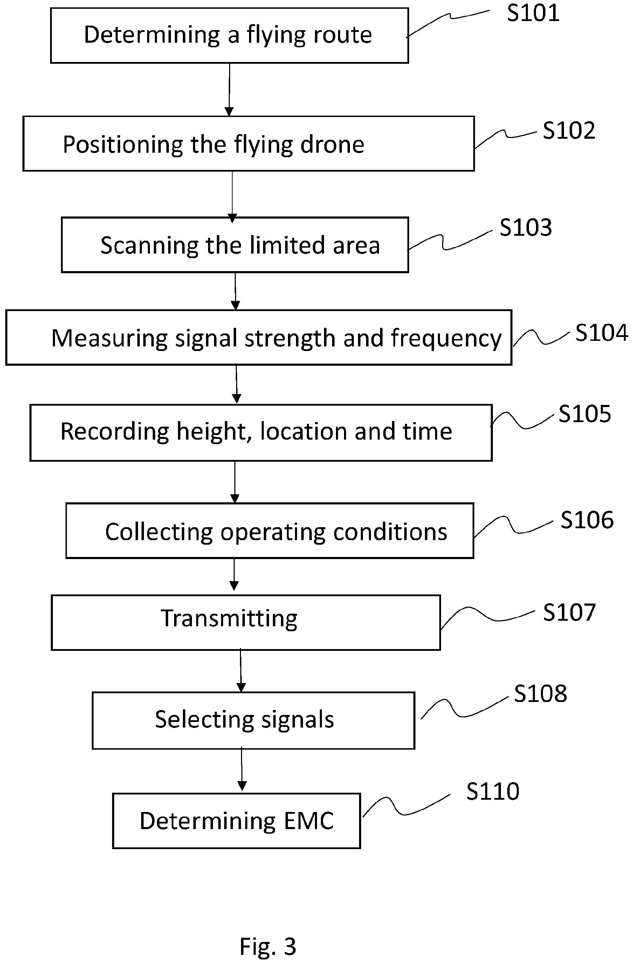

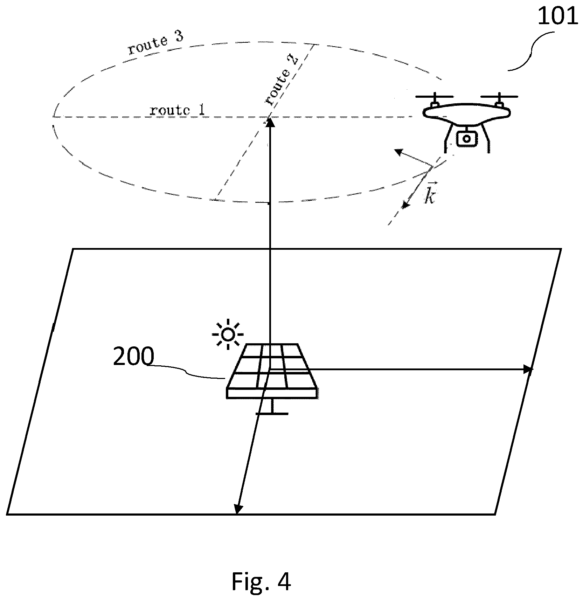

In one embodiment, the unmanned aerial system 100 comprises an interface 102. The interface 102 can be software, a mix of software and hardware in the form of hardwired connections, different fieldbus solutions and communication protocols. In some embodiments, the interface 102 is a display arranged in the drone 101, the ground system 300, or in a separate terminal. Fig. 2 shows the scenario that the interface 102 is arranged in the ground system 300. The interface 102 may be used to determine a flying route for the drone 101, so that the drone 101 can follow the route when it is performing the measuring or test task. This is corresponding to the step S101 in fig. 3. In some embodiments, there may be a default flying route which is pre-set in the unmanned aerial system 100 and the drone 101 can automatically follow the default flying route. In some other embodiment, the flying route can be set by the system or user according to the environment. In some other embodiments, the flying route can be adjusted during the task according to the environment or operating conditions, for example, when there are obstacles on the flying route or the signal strength is too weak to measure or the weather condition on one route is too bad to perform the task. The drone 101 should be able to operate in sensitive areas such as close to electrical facilities and infrastructures. In some other embodiments, the flying route can be adjusted so that the drone can overcome topography and geography differences. For example, it shall be manoeuvrable when hills and woods attenuate its connection with the ground system and in critical situations it shall move to a location where it can establish the connection again. One exemplary flying route for the drone is shown in **Fig. 4**.

The drone 101 has a controller 110 to control the operation of the drone 101, and the control can be automatic and manual. The EMC measurement and test shall be carried out by dedicated antenna system equipped on the drone 101. The antenna system shall be able to measure in a broad frequency band that reflect actual transmission of disturbance. Depending on measuring height and resolution it may be necessary that the drone 101 is equipped with different antennas. The antenna system may be selection of standard antennas or customized antennas. It is also important to combine different types of antennas according to measurement situations. The manoeuvrability and stability are important for the whole system and shall meet different weather conditions, such as rain, wind and dark. In such case, the angel of the antennas shall be adjustable. The drone 101 can be controlled wirelessly, or via a cable from ground.

Once the drone 101 has begun to fly following the route, the drone 101 should have meticulous pinpointing ability to orientate in space. In the step S102 of fig. 3, a positioning unit 103 in the drone 101 is configured to position the drone 101 to enable precise use of the drone 101, the accuracy shall be high and can be based on satellite navigation system, ground based positioning system or a combination. A positioning system in the positioning unit 103 can be adapted for different satellite and ground-based positioning systems. The drone 101 may further comprise a scanning unit 104 such as HD cameras, embedded cameras, thermal cameras, infrared camera sensors and image capture systems etc. The scanning unit 104 is used to scan and image the limited area. This is corresponding to the step S103 of fig. 3. The scanning of the limited area can be performed in different ways according to the operating environment. In some embodiments, the scanning is firstly to perform overall scanning and then perform fine scanning on selected smaller interesting areas. The distribution of broad to fine pitch shall be developed concerning measurements efficiency. It is necessary to adaptively, manually or automatically determine actual situation, the disturbance distribution thus to operate the drone accordingly.

The drone 101 further comprises a measuring unit 105 for measuring the electromagnetic signal strength and frequency. The measurement can be made as a spot measurement in combination with the positioning unit 103 to categorize a source, e.g. at different heights or the power of a transmitting antenna in different situations such as in an urban environment where reflections between buildings can have both higher and lower power. The measuring shall be performed at different heights and/or locations around the target thus sufficient amount of data is measured. The measuring unit 105 can perform the measurement automatically, and it can also perform the measurement by manual controlling. The measuring unit 105 performs measurements around the target electrical device 200, and also performs measurements on the target electrical device 200. This is corresponding to the step S104 in fig. 3.

The unmanned aerial system shall be used for measurement from large areas to small precisely pinpointed around the target electrical device 200. The measurement can be of both high and low resolution for suitable amount of data. This can, for example, be achieved with higher speed or slower measurement sweeps. A recording unit (not shown in the drawings) is further arranged to accurately and fast record the measured electromagnetic signal strength and frequency, measuring heights and locations, operating time.

The strength and frequency measurement of the electromagnetic signals by the measuring unit 105 is performed on a broad frequency spectrum, e.g., 30MHz to several GHz. In special cases, the frequency spectrum for measuring can be 9kHz to several GHz. Since the measurement is performed in an outside and natural area where the target electrical device 200 is deployed/installed, the measured electromagnetic signals varied a lot. For example, the electromagnetic signals can be electromagnetic interference which are quite small, e.g., in µV/m level. The electromagnetic signals can also be radio signals which are being used in radio communication, e.g., radio broadcast or cellular communication. These kind of radio signals can be very strong, e.g., in V/m level.

Therefore, the measurement unit 105 should have the ability of measuring electromagnetic signals range from µV/m to V/m. Typically, the measurement unit 105 measured the electromagnetic signals which are stronger than 1 µV/m. This can be performed by equipping preamplifier or attenuator to the measurement unit 105. Therefore, the weak signals can be amplified and measured, and the strong signals can be attenuated and measured. Alternatively, other alternatives for measurement can be used. The alternatives include using frequency filter so that only the signals within certain frequencies are measured, adjusting measuring bandwidth, turning antenna direction by turning the drone direction, changing antenna, etc.

Furthermore, the drone 101 itself is an electrical device, therefore, the drone 101 may have disturbance to the measurement of the electromagnetic signals in the environment. In order to decrease the impact of the electromagnetic signal emitted from the drone 101, the power supply unit and signal lines of the drone 101 can be contained in shielding materials, e.g., can be wrapped in shielding sheets or being contained in a box made of shielding material. Another way of decreasing the drone 101 disturbance is to adjust the measuring antenna in measuring unit 105 to a direction that is not sensitive to the electromagnetic signals emitted by the drone 101.

Operating conditions are the environment conditions which are in the limit area, such as humidity and solar radiation around the target electrical device 200. The operating conditions may have impact on the measured electromagnetic, e.g., humidity may attenuate electromagnetic signal, so the measured strength of the electromagnetic signal in the limit area may decrease. For another example, strong solar radiation may make the measured strength of the electromagnetic signal increase. As a result, the operating conditions are important additional information when considering EMC and need to be collected. Operating conditions can be collected through a plurality of sensors 106 arranged on drone 101 and optionally be recorded by the recording unit, so that the operating conditions can be additional information to the EMC determination result. This is corresponding to the step S106 in fig. 3. This will be discussed in detail in the text below.

The drone 101 may further comprises a transmitting unit 109 for transmitting signals. Such transmitting unit 109 diverse from the electromagnetic measuring unit 105 so it only transmits and not measures. When the strength and frequency of electromagnetic signals are measured and the operating conditions are collected, the measured data and collected data is transmitted by the transmitting unit 109 to the computing unit 107 in the ground system 300. This is corresponding to the step S107 in fig. 3.

A computing unit 107 can be arranged in the ground system 300 or separately such as in a host or a computer. When receiving the measured strength and frequency of electromagnetic signals, the computing unit 107 selects those electromagnetic signals which are outside the bandwidths authorized to radio communications.

As discussed before, in limited area around the target electrical device 200, both electromagnetic interference signals and radio communicating signals exist. According to the definition of EMC, radio communicating signals, such as the radio signals used in radio broadcasting, cellular communication, etc, are not compliant to determining the EMC. These radio communicating signals have their own authorized bandwidth, which is regulated in International Telecommunication Union (ITU) standards and/or local regulations. Therefore, among all the measured signals, only the electromagnetic signals which are outside the authorized bandwidth are selected. The signals within the authorized bandwidth are deemed to be radio communication signals and should not be used for EMC determination, so these signals are ignored. This is corresponding to the step S108 in fig. 3.

After selecting, the computing unit 107 performs a comparison between the selected measured signal strength with an EMC threshold in corresponding frequency, i.e., different frequencies have different EMC thresholds. Since the measured signal strengths indicates the electromagnetic interference in the area, if the measured signal strength is over the EMC threshold, it is determined that the EMC of the target electrical device 200 in corresponding frequency does not fulfil the EMC requirement. If the measured signal strength is below the EMC threshold, it is determined that the EMC of the target electrical device 200 is corresponding frequency fulfils the EMC requirement. The EMC thresholds in different frequencies can be predefined in related EMC standards. Common EMC thresholds can be ranged from 30 µV/m to 700 µV/m. The EMC thresholds defined in EMC standards may also be amended in the future. The collected operating conditions is additional information to the EMC determination result, that is, as an extra information for the EMC determination result. For example, the EMC determination result is: "the EMC of the target electrical device 200 fulfils the EMC requirement in frequency 50MHz, the measurement is performed in high humidity environment", or "the EMC of the target electrical device 200 does not fulfil the EMC requirement in 1 GHz, the measurement is performed in strong solar radiation environment". This determination is corresponding to the step S110 in fig. 3.

Alternatively, the drone 101 can also comprises a drone computing unit 111, so the drone computing unit 111 can also perform the selecting S108, and determining S110 steps in the similar way of the external computing unit 107. Therefore, at least a part of the electromagnetic signals can be selected, measured and/or determined by the drone computing unit 111, and does not need to be transmitted to the computing unit 107.

The EMC determination results can be presented to the user, e.g., via a display 108. The display can be arranged as the interface 102 or be a separate display connected with the computing unit 107. The forms of the presentation can be one of maps, tables, graphs, pictures and descriptive text or any of their combinations. It is important that the representing of the result is versatile enough to make presentations according to different requirements. In some embodiments, the form is maps, such as 2D maps and 3D maps. To build 2D and 3D maps, the amount of the scanned data must be sufficient. However, the recording and reporting of data is not limited to 2D or 3D maps, it can be combinations of different forms. For example, it can be a 3D map of different resolutions over selected area, pinpointed graph of certain aspect as distribution in one direction, table of values for different situations and measurement of radio systems. The collected operating conditions are presented to the user as well, as additional information of the determination result of EMC, so that the user is aware of the operating condition.

The representations of the result shall be flexible so many different combinations can be made from the drone sensors and electromagnetic measurement system. For example, in solar energy systems, presenting determined EMC correlated to solar radiation or change of weather type.

According to another embodiment, if the measured electromagnetic signal strength is above a predefined threshold, it may indicate there is an electrical device which is generating disturbance in vicinity. The route of the drone 101 can be adjusted so that the drone flying towards the position where the measured signal strength is above the predefined threshold in a predetermined frequency, i.e., the drone 101 flying towards the signal source of which generating disturbance so as to perform a closer and pinpointed measurement.

According to another embodiment, the method further comprises determining electromagnetic disturbance based on the measured S104 strength and frequency of the electromagnetic signal. The electromagnetic disturbance is a different concept from EMC. Besides determining EMC, the measured strength and frequency of the electromagnetic signals can also be used for determining electromagnetic disturbance in the electromagnetic environment.

To ensure the accuracy of the measurement and test, the entire system shall be calibrated in at least two ways. The electromagnetic measurement system with antenna, possible amplifiers, cables, connectors, possible transmission, and receiving instrument shall exclusively be calibrated. This calibrating shall be carried out using calibrated measurement system and instruments most likely but not limited to common calibration for EMC-properties. The entire unmanned aerial system shall also be calibrated for its use with all its sensors and connections.

Fig. 3 illustrates an exemplary flow chart of a method for determining the EMC for a target electrical device 200 in a limited area around the target electrical device 200. As discussed above, the method first determines a flying route for the drone in S101, when the drone flies following the flying route, it positions its own position in S102 for precise operation of the drone. To help accurate measurement and mapping of the result, the drone performs a scanning of the limited area around the target electrical device in S103. The scanning can be performed in different ways according to the operating environment as described above. Then a step of measuring the electromagnetic signal strength and frequency at different heights and/or locations around the target electrical device S104 is performed so that sufficient data is measured for the presentation of the result. Optionally, the height of the measuring spot, the location of the measuring spot and measuring time is recorded and the operating conditions such as humidity and solar radiation around the target electrical device 200 are collected in S105 for the accurate determination of the EMC. In S107 the measured electromagnetic signal strength and frequency and collected operating conditions are transmitted to the computing unit 107. Among the received measured signals, the computing unit 107 selects the electromagnetic signals which have frequency outside the bandwidth authorized to radio communication in S108. In S110, EMC of the target electrical device 200 is determined in respective frequency. If the measured electromagnetic signal strength is lower than the EMC threshold in corresponding frequency, the EMC is determined to fulfill the EMC requirement of the frequency. If the measured electromagnetic signal strength is higher than the EMC threshold in corresponding frequency, the EMC is determined to not fulfill the EMC requirement of the frequency, wherein the collected operating conditions being additional information to the EMC determination result. Optionally, the determined results of EMC can be presented to a user. The above steps are performed by specific units in the unmanned aerial system 100 as illustrated above.

Optionally, the method may further comprise testing electromagnetic susceptibility of the target electrical device 200. The testing can be performed by a susceptibility test unit 112 on the drone 101. The susceptibility test unit 112 is more limited since it need more power and stronger amplifiers to perform the test. However, such units can be used in shorter periods and probably more selective targets. It may comprise extra power storage, amplifier, cables, and signal generator.

It will be appreciated that additional advantages and modifications will readily occur to those skilled in the art. Therefore, the disclosures presented herein and broader aspects thereof are not limited to the specific details and representative embodiments shown and described herein. Accordingly, many modifications, equivalents, and improvements may be included without departing from the spirit or scope of the general inventive concept as defined by the appended claims and their equivalents.

## Claims

1. A method for determining electromagnetic compatibility, EMC, for a target electrical device (200) in a limited area around the target electrical device (200) by means of an unmanned aerial system (100), the unmanned aerial system (100) comprising a drone (101), an interface (102), a computing unit (107), wherein the drone (101) comprising a positioning unit (103), a scanning unit (104), a measuring unit (105), a sensor (106) and a transmitting unit (109), the method comprising:
- determining (S101), by the interface (102), a route for the drone,
- positioning (S102), by the positioning unit (103), the drone (101) flying along the route,
- scanning (S103), by the scanning unit (104), the limited area around the target electrical device (200),
- measuring (S104), by the measuring unit (105) of the drone (101), electromagnetic signal strength and frequency at different heights and/or locations around the target electrical device (200) in the limited area,
- collecting (S106), by the sensor (106), operating conditions around the target electrical device (200) in the limited area,
- transmitting (S107), by the transmitting unit (109), the measured (S104) electromagnetic signal strength and frequency and collected (S106) operating conditions to the computing unit (107),
- selecting (S108), by the computing unit (107), the electromagnetic signals which having frequencies outside the bandwidths authorized to radio communications,
- determining (S110), among the selected (S108) electromagnetic signals, by the computing unit (107), if the EMC of the target electrical device (200) fulfills EMC requirement by comparing the selected measured (S104) electromagnetic signal strength with respective threshold in corresponding frequencies; when the selected measured (S104) electromagnetic signal strength is lower than the threshold, the EMC of the target electrical device (200) is determined to fulfil the EMC requirement in corresponding frequency, wherein the collected (S106) operating conditions being additional information to the EMC determination result.

2. The method according to claim 1, wherein the drone (101) further comprises a drone computing unit (111), so that the steps of selecting (S108) and determining (S110) can also be performed in the drone computing unit (111) on at least a part of the electromagnetic signals.

3. The method according to claim 1 or 2, the method further comprises adjusting the route of the drone (101) based on the measured electromagnetic signal strength, so that the drone (101) flying towards the position where the measured electromagnetic signal strength is higher than a predefined strength threshold in a predetermined frequency.

4. The method according to claim 1, wherein the measuring is made as a spot-measurement.

5. The method according to any of the claims 1-4, wherein the method further comprises presenting the determination result of EMC, the form of the presenting is at least one of the following: maps, tables, graphs, pictures and descriptive text, wherein the collected (S106) operating conditions are presented as additional information of the determination result of EMC.

6. The method according to any of claims 1 to 5, further comprising recording the height of the measuring spot, the location of the measuring spot and measuring time.

7. The method according to any of claims 1 to 6, further comprising: testing electromagnetic susceptibility of the target electrical device (200).

8. The method according to any of the claims 1-7, further comprising:
determining electromagnetic disturbance based on the measured (S104) strength and frequency of the electromagnetic signal.

9. An unmanned aerial system (100) for determining electromagnetic compatibility, EMC, for a target electrical device (200) in a limited area around the target electrical device (200), the unmanned aerial system (100) comprising a drone(101), an interface(102) and a computing unit (107), the drone (101) comprising a positioning unit (103), a scanning unit (104), a measuring unit (105), a sensor(106), and a transmitting unit (109), wherein the unmanned aerial system (100) is operative for:
- determining, by the interface (102), a route for the drone,
- positioning, by the positioning unit (103), the drone (101) flying along the route,
- scanning, by the scanning unit (104), the limited area around the target electrical device (200),
- measuring, by the measuring unit (105) of the drone (101), electromagnetic signal strength and frequency at different heights and/or locations around the target electrical device (200) in the limited area,
- collecting, by the sensor (106), operating conditions around the target electrical device (200) in the limited area,
- transmitting, by the transmitting unit (109), the measured (S104) electromagnetic signal strength and frequency and collected (S106) operating conditions to the computing unit (107),
- selecting, by the computing unit (107), the electromagnetic signals which having frequencies outside the bandwidths authorized to radio communications,
- determining, by the computing unit (107), if the EMC of the target electrical device (200) fulfils EMC requirement by comparing the selected measured (S104) electromagnetic signal strength with respective threshold in corresponding frequencies; when the selected measured (S104) electromagnetic signal strength is lower than the threshold, the EMC of the target electrical device (200) is determined to fulfil the EMC requirement in corresponding frequency, wherein the collected operating conditions being additional information to the EMC determination result.

10. The unmanned aerial system (100) according to claim 8, the unmanned aerial system (100) is further operative for performing the method in claims 2-8.
